# EUROPÄISCHE PATENTANMELDUNG

(11) **EP 4 513 225 A1**
(43) Veröffentlichungstag der Anmeldung: **26.02.2025**
(21) Anmeldenummer: 24191501.6
(22) Anmeldetag: 29.07.2024
(51) Int. Cl.: G01S 7/40, G01S 7/497, G01S 7/03, G01S 13/931, G01S 17/931, H10N 30/857, H10N 30/87

(54) **SENSORABDECKUNG, SENSORSYSTEM SOWIE KRAFTFAHRZEUG**

(30) Priorität: 16.08.2023 DE 102023207868
(71) Anmelder: VOLKSWAGEN AG, 38440 Wolfsburg (DE)
(72) Erfinder: Tietje, Alexander, 29392 Wesendorf (DE)

(57) **Zusammenfassung**

Die Erfindung betrifft eine Sensorabdeckung (10) für ein Sensorsystem (12) zum Entfernen von wetterbedingten Verschmutzungen zur ungestörten Verwendung eines Sensors (14) des Sensorsystems (12), wobei die Sensorabdeckung (10) zumindest einen Sensorabschnitt (16) aufweist, wobei die Sensorabdeckung (10)
zumindest einen Grundkörper (18) zur Überdeckung des Sensors (14) aufweist, wobei auf dem Grundkörper (18) zumindest ein Elektrodenabschnitt (20) vorgesehen ist, und wobei die Sensorabdeckung (10) zumindest einen piezoaktiven Aktuator (22) zur Erzeugung von Schallwellen in der Sensorabdeckung (10) aufweist, wobei der zumindest eine piezoaktive Aktuator (22) an dem zumindest einen Elektrodenabschnitt (20) des Grundkörpers (18) angeordnet ist.

## Beschreibung

Die Erfindung betrifft eine Sensorabdeckung für ein Sensorsystem zum Entfernen von wetterbedingten Verschmutzungen zur ungestörten Verwendung eines Sensors des Sensorsystems, ein Sensorsystem sowie ein Kraftfahrzeug.

Im Rahmen des autonomen Fahrens steigen mit zunehmendem Automatisierungsgrad die Anforderungen an die Sensoren der dazu notwendigen Fahrerassistenzsysteme. Diese Sensoren sind dabei vor allem in der Fahrzeugfront, aber auch im Heck, verbaut. Hier nehmen sie eine exponierte Position ein. Mögliche Verbauorte der Sensoren sind hinter dem Markenemblem im Kühlerschutzgitter, hinter einer Blende im Stoßfänger oder im Lüftungsgitterbereich. Insbesondere Witterungseinflüsse wie Regen, Eisbildung, Verschmutzungen oder Salzanhaftungen beeinflussen hierbei die Zuverlässigkeit des Funktionsumfanges, welcher in der Regel auch Eingriffe in das Lenk-, Brems- und Beschleunigungsverhalten eines Automobils beinhaltet (z.B. automatische Geschwindigkeitssowie Abstandsregelung).

So beeinflussen oben genannte Randbedingungen das Transmissionsverhalten der Radome für Strahlung des elektromagnetischen Spektrums, wodurch insbesondere Radarsensoren in ihrer Funktionalität eingeschränkt werden können, indem sie Fehlinformationen liefern, oder gänzlich ausfallen.

Die damit einhergehenden Folgen können das Nichterkennen von Hindernissen oder der Umgebung im Allgemeinen sein. Auch das Gefühl von Wertigkeit beim Kunden sowie das Vertrauen in die Sicherheit eines sich autonom bewegenden Fahrzeuges können bei wiederkehrendem Ausfall von Fahrerassistenzsystemen betroffen sein.

Aus dem Stand der Technik sind bereits Schutzabdeckungen bekannt. Dabei sind folgende Möglichkeiten der Entfernung der Verunreinigungen oder Vereisung bei Schutzabdeckung bekannt:
- konstruktive Ausgestaltung der Schutzabdeckung, so, dass Schmutz oder Wasser durch den Windfluss bzw. -druck abgetragen werden. Diese Methode ist jedoch stark von der Anströmung der Schutzabdeckung bzw. der jeweiligen Witterung abhängig.
- Manipulation der Oberfläche, um die Adhäsion von Wasser, Eis oder Schmutzpartikeln zu erschweren. Diese Maßnahme erschwert das Anhaften von Schmutzpartikeln, ein Vereisen komplett vermeiden oder beseitigen kann sie jedoch nicht.
- Einbringen von Wärme, wobei Heizungen in der Schutzabdeckung verbaut sind. Diese können jedoch Wechselwirkungen mit der emittierten oder detektierten elektromagnetischen Strahlung der Sensoren eingehen, und sind zudem sehr kostenintensiv. Insbesondere Technologien, welche auf Polarisation des Elektromagnetischen-Feldes beruhen, können hier aufgrund einer Filterwirkung des Drahtnetzes nur bedingt eingesetzt werden, da bisher metallische Leiter wie Kupfer zur Beheizung benutzt werden.

Aus der DE 10 2013 223 783 A1 ist eine Radomreinigung bekannt, welches das Anhaften von Schmutz und die Entstehung von Eis dadurch erschwert, in dem ein externer Ultraschallschwinger, der mit dem Radom, also der Abdeckung eines Sensors, gekoppelt wird, einen Ultraschallfrequenz in die Abdeckung einbringt. Allerdings setzt diese wiederum konstruktive Maßnahmen voraus, um in dem Bereich eines Radars den Ultraschallschwinger unterzubringen und den Sensor vor Umwelteinflüssen zu schützen.

Es ist daher eine Aufgabe der vorliegenden Erfindung, wenigstens einen der voranstehend beschriebenen Nachteile zumindest teilweise zu überwinden. Insbesondere ist es Aufgabe der Erfindung eine einfache und sichere Enteisung und Reinigung einer Sensorabdeckung zur Verfügung zu stellen.

Die voranstehende Aufgabe wird gelöst durch eine Sensorabdeckung mit den Merkmalen des unabhängigen Patentanspruchs 1, durch ein Sensorsystem mit den Merkmalen des unabhängigen Patentanspruchs 11 sowie durch ein Kraftfahrzeug mit den Merkmalen des unabhängigen Patentanspruchs 13. Weitere Merkmale und Details der Erfindung ergeben sich aus den Unteransprüchen, der Beschreibung und den Zeichnungen. Dabei gelten Merkmale und Details, die im Zusammenhang mit der erfindungsgemäßen Sensorabdeckung beschrieben sind, selbstverständlich auch im Zusammenhang mit dem erfindungsgemäßen Sensorsystem und/oder im Zusammenhang mit dem erfindungsgemäßen Kraftfahrzeug und jeweils umgekehrt, sodass bezüglich der Offenbarung zu den einzelnen Erfindungsaspekten stets wechselseitig Bezug genommen wird bzw. werden kann.

Ein erster Aspekt der Erfindung ist eine Sensorabdeckung für ein Sensorsystem zum Entfernen von wetterbedingten Verschmutzungen zur ungestörten Verwendung eines Sensors des Sensorsystems, wobei die Sensorabdeckung zumindest einen Sensorabschnitt aufweist, wobei die Sensorabdeckung zumindest einen Grundkörper zur Überdeckung des Sensors aufweist, wobei auf dem Grundkörper zumindest ein Elektrodenabschnitt vorgesehen ist, und wobei die Sensorabdeckung zumindest einen piezoaktiven Aktuator zur Erzeugung von Schallwellen in der Sensorabdeckung aufweist, wobei der zumindest eine piezoaktive Aktuator an dem zumindest einen Elektrodenabschnitt des Grundkörpers angeordnet ist.

Der Sensorabschnitt ist dabei der Bereich bzw. Abschnitt der Sensorabdeckung, der den Funktionsbereich des Sensors abdeckt bzw. überdeckt. Dieser stellt sicher, dass der Sensor gegen Umwelteinflüsse geschützt ist und ungestört verwendet werden kann.

Wie oben bereits beschrieben, weist die Sensorabdeckung einen Grundkörper auf, auf welchem mittels des zumindest einen Elektrodenabschnitts der zumindest eine piezoaktive Aktuator angeordnet ist. Demnach steht der piezoaktive Aktuator mit dem Grundkörper in einer Art Wirkverbindung. Auch der Grundkörper weist den Sensorabschnitt bzw. einen Teil des Sensorabschnitts der Sensorabdeckung auf. Der Elektrodenabschnitt und der Sensorabschnitt können einander überlappen oder nebeneinander angeordnet sein oder gar die gleiche Erstreckung aufweisen.

Mittels der Anordnung des piezoaktiven Aktuators kann ein Ultraschall in den Grundkörper übertragen werden, sodass eventuelle Anhaftungen oder Verschmutzungen mittels des Ultraschalls von der Sensorabdeckung gelöst werden können.

Der Ultraschall sorgt dafür, dass
a) die Adhäsion von Wassertropfen, Schmutzpartikeln, Salzanhaftungen sowie die Nukleation von Eiskristallen durch geeignete Modenwahl des Frequenzbereichs des Ultraschalls sowie die damit einhergehende Amplitude der mechanischen Schwingungen dahingehend beeinflusst wird, dass Schmutz weniger gut an der der Witterung ausgesetzten Oberfläche haftet, und Eis sich gar nicht erst oder nur erschwert bilden kann,
   und/oder
b) direkt Wärme in der Beschichtung oder dem piezoaktiven Sensorabdeckung erzeugt wird, um ein Abtauen einer Vereisung auf der äußeren Oberfläche zu unterstützen.

Mittels des piezoaktiven Aktuators können mechanische Oberflächenwellen im Grenzschichtbereich bzw. in dem Grundkörper erzeugt werden. Die Frequenz wird hierbei so gewählt, dass Anhaftungen, Vereisungen, o. ä. durch die eingebrachte Energie entweder einen Phasenwechsel durchlaufen (z.B. Schmelzen oder Verdampfen), oder durch Wahl einer geeigneten Frequenz bzw. einer Amplitude einer erzwungenen Schwingung, idealerweise im Frequenzbereich der Eigenmoden der Anhaftungen, erfahren. Durch das Erreichen des Resonanzfalles sollen Kohäsionskräfte innerhalb der anhaftenden Schichten sowie Adhäsionskräfte in der Grenzschicht zwischen der Anhaftung und der äußeren Oberfläche der Sensorabdeckung überwunden werden. So kann ein Ablösen der Verunreinigungen oder Vereisung herbeigeführt werden. Weiterhin soll die Möglichkeit bestehen, die Frequenz so zu wählen, dass es zu molekularen Reibungsprozessen innerhalb des piezoaktiven Aktuators oder der Oberfläche kommt, welche dann Wärme erzeugen. Diese kann ein Abtauen zusätzlich unterstützen.

Im Rahmen der Erfindung kann es von Vorteil sein, dass jeder piezoaktive Aktuator eine erste Elektrodenbeschichtung, eine zweite Elektrodenbeschichtung, und eine piezoaktive Schicht aufweist, wobei zumindest ein Abschnitt der piezoaktiven Schicht zwischen der ersten Elektrodenbeschichtung und der zweiten Elektrodenbeschichtung angeordnet ist.

Dies stellt eine besonders einfache und kostengünstige Art des Aufbaus eines piezoaktiven Aktuators für die Sensorabdeckung dar. Durch den Schichtaufbau wird die eigentliche Konstruktion nicht beeinflusst bzw. können die geringen Schichtdicken einfach in die Konstruktion mit einberechnet werden. Gleichzeitig können diese schnell und einfach auf existierende Sensorabdeckungen aufgebracht werden, und sind somit nachrüstbar. Aufgrund des Schichtaufbaus sind keine weiteren Bauteile nötig, welche in dem Bereich des Sensors eingebracht werden müssen. Eine derartige Lösung stellt somit eine vereinfachte Lösung dar.

Mittels der Elektronenbeschichtung kann auf einfache Art und Weise die Ultraschallfrequenz zum Reinigen der Sensorabdeckung in die piezoaktive Schicht eingeleitet werden. Dies löst die Verschmutzungen und die Vereisung an der nach außen gerichteten Oberfläche der Sensorabdeckung.

Im Rahmen der Erfindung ist es denkbar, dass der zumindest eine Sensorabschnitt sensortransparent ist. Die Sensortransparenz des Sensorabschnitts stellt sicher, dass die von dem Sensor durchzuführenden Messungen ungestört ausgeführt werden können. Beispielsweise wird sichergestellt, dass zumindest in dem Bereich des zumindest einen Sensorabschnitts der Sensorabdeckung die Durchgängigkeit für eine Radarmessung oder Lidarmessung gegeben ist.

Es kann im Rahmen der Erfindung vorgesehen sein, dass der zumindest eine Elektrodenabschnitt abschnittsweise oder vollflächig auf dem Grundkörper vorgesehen ist.

Bei einem abschnittsweisen Verlauf des zumindest einen Elektrodenabschnitts auf dem Grundkörper ist es besonders vorteilhaft, wenn der zumindest eine Elektrodenabschnitt entlang des Sensorabschnitts verläuft. Der zumindest eine Elektrodenabschnitt kann dabei teilweise oder vollständig um den Umfang des Sensorabschnitts verlaufen. Dabei kann die erste Elektrodenschicht und die zweite Elektrodenschicht den gleichen Verlauf aufweisen, wie der zumindest eine Elektrodenabschnitt. Denkbar ist hier auch, dass die Flächen der ersten und zweiten Elektrodenschicht und des Elektrodenabschnitts sich voneinander in zumindest geringen Maße unterscheiden. Allerdings können die Flächen des Elektrodenabschnitts und die der ersten und zweiten Elektrodenschicht einander entsprechen.

Dies erleichtert das Aufbringen der ersten und zweiten Elektrodenschicht auf den Grundkörper, da eine vordefinierte Fläche des zumindest einen Elektrodenabschnitts gegeben ist.

Dabei kann die Fläche der piezoaktiven Schicht der Fläche des zumindest einen Elektrodenabschnitts bzw. der ersten und/oder zweiten Elektrodenschicht entsprechen.

Gleichzeitig ist hier denkbar, dass die piezoaktive Schicht eine Fläche aufweist, die sich von der Fläche des Elektrodenabschnitts unterscheidet. Beispielsweise kann diese die Fläche des Grundkörpers aufweisen und nur in einem Abschnitt mit der ersten Elektrodenschicht und der zweiten Elektrodenschicht in Kontakt stehen. Dies lässt eine variable Anordnung des zumindest einen Elektrodenabschnitts, respektive der piezoaktiven Schicht zu.

Die Beschichtung kann vom Elektrodenmaterial ausgespart werden, sollte sie eine zu geringe Sensortransparenz aufweisen. In diesem Falle kommt es anstatt zu einer vollflächigen Anregung der piezoaktiven Beschichtung nur zu einer Schwingungsanregung im Randbereich, also dem Elektrodenabschnitt. In diesem Falle können auch nicht sensortransparente Materialien als Elektroden verwendet werden.

Sollte die piezoelektrische Schicht selbst eine zu schlechte Sensortransparenz aufweisen, so kann der durchstrahlte Bereich auch von ihr ausgespart werden. Eine Weiterleitung der Schallwellen in den durchstrahlten Sensorabschnitt würde dann über Körperschall geschehen, indem die Schallwellen ausschließlich durch die Ankoppelung zwischen Beschichtung und Grundkörper übertragen werden.

Es ist ferner denkbar, dass die piezoaktive Schicht jedes piezoaktiven Aktuators eine Dicke von 5 nm bis 500 nm, vorzugsweise eine Dicke von 10 nm bis 250 nm, weiter vorzugsweise 15 nm bis 150 nm, aufweist.

Eine Dicke der piezoaktiven Schicht in den genannten Bereichen stellt die Übertragung der Ultraschallfrequenz zum Entfernen der Verschmutzungen auf der Außenseite der Sensorabdeckung sicher. Dabei weist jede piezoaktive Schicht der Sensorabdeckung eine Dicke in diesen Bereichen auf. Sind mehrere piezoaktive Schichten in der Sensorabdeckung bzw. auf dem Grundkörper vorgesehen, können die einzelnen piezoaktiven Schichten jeweils unterschiedliche Dicken aufweisen. Auch ist es denkbar, dass die piezoaktiven Schichten bzw. die piezoaktive Schicht im Bereich des zumindest einen Elektrodenabschnitts eine andere Dicke aufweist als im Bereich des Sensorabschnitts. Die Dicke der piezoaktiven Schicht kann somit über ihren Querschnitt variieren.

Diese Dicken stellen die Übertragung des Ultraschalls auf den Grundkörper sicher, und eignen sich insbesondere für eine Anordnung des Elektrodenabschnitts bzw. der piezoaktiven Schicht entlang des Sensorabschnitts. Dabei muss in diesem Fall nicht darauf geachtet werden, dass die piezoaktive Schicht und die Elektrodenschichten sensortransparent sind. Demnach können hier kostengünstigere Beschichtungsverfahren oder Materialien zum Einsatz kommen.

Auch ist es denkbar, dass die piezoaktive Schicht jedes piezoaktiven Aktuators in dem zumindest einen Sensorabschnitt eine Dicke von 5 nm bis 50 nm, vorzugweise 10 nm bis 45 nm, weiter vorzugsweise 15 nm bis 40 nm, aufweist.

Ist die piezoaktive Schicht auch im Bereich der Sensorabschnitte vorgesehen, wird durch eine Dicke im Bereich von 5 nm bis 50 nm sichergestellt, dass die piezoaktive Schicht sensortransparent ist. Dies stellt die Funktionsweise des dahinterliegenden Sensors sicher.

Auch hier ist es vorstellbar, dass die Dicke der piezoaktiven Schicht über den Querschnitt der piezoaktiven Schicht variiert. Dabei kann im Bereich des Sensorabschnitts eine sensortransparente Schichtdicke von 5nm bis 50 nm vorgesehen sein und im Bereich des Elektrodenabschnitts eine Dicke größer als 50 nm vorgesehen sein.

Im Rahmen der Erfindung ist es optional möglich, dass die piezoaktive Schicht ein Polyvinylfluorid ist.

Die Verwendung von Polyvinylfluorid eignet sich besonders für die piezoaktive Schicht, da eine Anregung durch die erste und zweite Elektrodenschicht einfach bewerkstelligt werden kann und gleichzeitig eine Sensortransparenz des Materials vorliegt.

Des Weiteren ist bei der Verwendung von Polyvinylfluorid die piezoaktive Schicht optisch transparent ausführbar und lässt gleichzeitig hohe Amplituden bei einer geringen Spannung zu, um den Ultraschall entsprechend weiterleiten zu können.

Ferner ist Polyvinylfluorid (PVDF) robust gegen physikalische, chemische Einwirkungen, wie das Einwirken von Ölen, Säuren oder Basen, und mechanische Einwirkungen, wie Abrieb oder

Schläge, von außen, insbesondere UV-Einstrahlung durch Tageslicht. Zusätzlich weist es die physikalischen Anforderungen für die Radartauglichkeit im erforderlichen Frequenzbereich, insbesondere hinsichtlich Dämpfung und Reflektivität, auf.

Ein weiterer Vorteil von PVDF als Piezoelektrikum ist das zusätzliche superhydrophobe Verhalten, wodurch eine Eisbildung verzögert wird und die Adhäsion von Eis verringert wird. Weiterhin kann die Beschichtung auch auf der witterungsabgewandten Sensorabdeckung aufgetragen werden.

Ferner kann es im Rahmen der Erfindung vorgesehen sein, dass die erste Elektrodenbeschichtung jedes piezoaktiven Aktuators und/oder die zweite Elektrodenbeschichtung jedes piezoaktiven Aktuators Indium-Zinn-Oxid oder fluoridiertes Zinnoxid oder aluminiumdotiertes Zinnoxid oder Antimon-Zinn-Oxid aufweist.

Die genannten zinnbasierten Materialien lassen eine einfache Anregung der piezoaktiven Schicht zu und lassen sich einfach auf den Grundkörper bzw. das Material der piezoaktiven Schicht aufsprühen. Demnach ist die Fertigung einer Sensorabdeckung mittels der genannten Materialien einfach und kostengünstig.

In Bezug auf die vorliegende Erfindung ist es vorstellbar, dass zumindest zwei piezoaktive Aktuatoren auf jeweils einem Elektrodenabschnitt vorgesehen sind, wobei die zumindest zwei piezoaktiven Aktuatoren separat modulierbar sind.

Durch die Verwendung von zumindest zwei Ultraschallquellen, also den piezoaktiven Aktuatoren, kann die eingebrachte Energie in Form des Ultraschalles erhöht werden.

Das Vorsehen von zumindest zwei piezoaktiven Aktuatoren steigert die Sicherheit der Reinigung der Sensorabdeckung. Ferner ist denkbar diese mit unterschiedlichen Frequenzen zu beaufschlagen, um unterschiedliche Frequenzen bzw. Wellen in das Material des Grundkörpers einbringen zu können, sodass die Reinigung bzw. die Enteisung sichergestellt und eventuell beschleunigt werden kann.

Denkbar ist, dass die beiden piezoaktiven Aktuatoren dann getrennt moduliert werden, sodass durch eine gezielte Phasenverschiebung der mechanischen Oberflächenwellen eine konstruktiver oder destruktiver Interferenz zwischen den unterschiedlichen Elementarwellen erzeugt werden kann. So kann gezielt eine Amplitudenresonanz herbeigeführt werden, wodurch ein Beseitigen von Anhaftungen, Vereisungen, etc. noch gefördert wird. Weiterhin können den Anhaftungen und Verschmutzungen eine "Richtung" vorgegeben werden, z.B. nach unten.

Ferner ist es vorstellbar, dass mehrere Abdeckungsschichten vorgesehen sind, wobei jede Abdeckungsschicht zumindest einen Grundkörper und zumindest einen piezoaktiven Aktuator aufweist.

Die Sensorabdeckung kann aus diversen Schichten bestehen. Dabei kann eine Laminierung mehrerer Abdeckungsschichten durchgeführt werden. Eine Abdeckungsschicht umfasst zumindest einen Grundkörper und zumindest einen piezoaktiven Aktuator. Dabei sind die Abdeckungsschichten so ausgelegt, dass sie beim Aufbringen auf eine bereits bestehende Abdeckungsschicht den piezoaktiven Aktuator abdecken, ohne eine Zwischenschicht zu bilden. Die einzelnen Schichten können somit den piezoaktiven Aktuator der jeweils unteren Abdeckungsschicht aufnehmen.

Dabei sollte eine ausreichende Adhäsion der Beschichtung auf dem Grundkörper oder der Abdeckungsschichten untereinander gegeben sein, um sich nicht selbst durch den eingebrachten Ultraschall abzulösen.

Ein zweiter Aspekt der Erfindung ist ein erfindungsgemäßes Sensorsystem, insbesondere für ein Kraftfahrzeug, aufweisend
zumindest einen Sensor,
zumindest eine Sensorabdeckung nach dem ersten Aspekt der Erfindung,
zumindest eine Spannungsquelle, und
zumindest einen Schallwandler,
wobei die zumindest eine Sensorabdeckung so angeordnet ist, dass der zumindest eine Sensorabschnitt der Sensorabdeckung den zumindest einen Sensor überdeckt und vor äußeren Umwelteinflüssen schützt, und
wobei die zumindest eine Spannungsquelle und der zumindest eine Schallwandler mit der zumindest einen ersten Elektrodenbeschichtung und mit der zumindest einen zweiten Elektrodenbeschichtung zum Erzeugen eines Ultraschalls elektronisch verbunden sind.

Das Sensorsystem kann somit sicherstellen, dass der Sensor mittels der Sensorabdeckung vor äußeren Einflüssen geschützt ist. Die Spannungsquelle und der Schallwandler können diverse Sensorabdeckungen mit einer Frequenz beaufschlagen, um so die Reinigung oder Enteisung der witterungsbehafteten Oberfläche der Sensorabdeckung sicherzustellen. Denkbar ist hier, dass eine Regelungseinheit vorsehbar ist, welche die Ultraschallfrequenz auf der jeweiligen Sensorabdeckung bzw. den jeweiligen Elektrodenabschnitt einer Sensorabdeckung steuern kann.

Die Spannungsquelle (z.B. Bordnetz) soll die Spannung in ihrer Pulslänge (bzw. Frequenz) und Amplitude modulieren können. So kann die Leistung der Ultraschallwellen sowie die Frequenz und Amplitude der dadurch erzeugten mechanischen Schwingungen an der Grenzfläche zwischen der Anhaftung und der Sensorabdeckung gezielt gesteuert werden.

Im Rahmen der Erfindung kann es von Vorteil sein, dass die Spannungsquelle und der Schallwandler ausgelegt sind, einen Frequenzbereich im Ultraschallbereich zu erzeugen, wobei sich der erzeugte Frequenzbereich von den Frequenzbereichen des überdeckten Sensors und/oder beabstandeter Sensoren unterscheidet.

Dies ist besonders vorteilhaft, da somit sichergestellt werden kann, dass der zum Reinigen benötigte Ultraschallbereich nicht die durch die dahinterliegenden Sensoren durchgeführten Messungen beeinflusst bzw. die Messungen der benachbarten Sensoren beeinflusst. Besonders vorteilhaft ist auch, wenn ein Ultraschallbereich bzw. ein Frequenzbereich gewählt wird, welcher von keinen der verbauten Sensoren verwendet wird.

Ein dritter Aspekt der Erfindung ist ein Kraftfahrzeug mit zumindest einem Sensorsystem nach dem zweiten Aspekt der Erfindung.

Dies ist besonders vorteilhaft, da die Reinigung und Enteisung der in dem Kraftfahrzeug verbauten Sensoren sichergestellt werden kann, wodurch sich die Sicherheit der Fahrerassistenzsysteme erhöht.

Im Rahmen der Erfindung ist es denkbar, dass das Sensorsystem ein Radarsystem und/oder ein Lidarsystem ist.

Dabei ist der Sensorabschnitt in vorteilhafterweise lidartransparent bzw. radartransparent und stellt vor allem die Abstandsmessung des Fahrerassistenzsystems sicher.

Vorteile, die zu der Sensorabdeckung gemäß dem ersten Aspekt der Erfindung ausführlich beschrieben werden, gelten gleichermaßen bei dem Sensorsystem gemäß dem zweiten Aspekt der Erfindung sowie dem Kraftfahrzeug gemäß dem dritten Aspekt der Erfindung.

Weitere Vorteile, Merkmale und Einzelheiten der Erfindung ergeben sich aus der nachfolgenden Beschreibung, in der unter Bezugnahme auf die Zeichnungen mehrere Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Dabei ist die Erfindung in den folgenden Figuren gezeigt:
Figur 1 eine schematische Darstellung einer ersten Sensorabdeckung mit einem Elektrodenabschnitt;
Figur 2 eine schematische Darstellung der ersten Sensorabdeckung in einem Schnitt A-A;
Figur 3 eine schematische Darstellung einer zweiten Sensorabdeckung mit zwei Elektrodenabschnitten;
Figur 4 eine schematische Darstellung der zweiten Sensorabdeckung in einem Schnitt B-B;
Figur 5 eine schematische Darstellung eines erfindungsgemäßen Sensorsystems;
Figur 6 eine schematische Darstellung eines erfindungsgemäßen Kraftfahrzeugs.

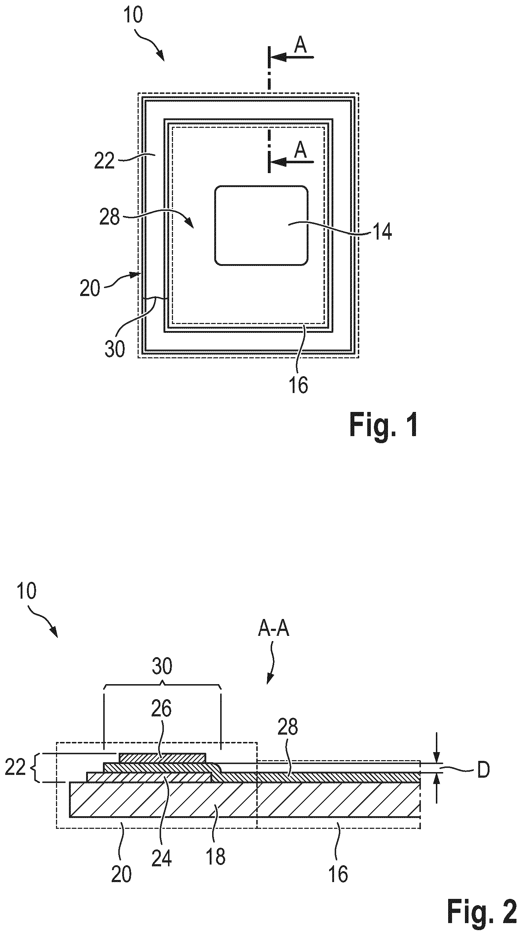

In den Fig. 1 bis 4 werden jeweils in einer Draufsicht und einem Schnitt zwei unterschiedliche Ausführungsformen einer Sensorabdeckung 10 für ein Sensorsystem 12 zum Entfernen von wetterbedingten Verschmutzungen zur ungestörten Verwendung eines Sensors 14 des Sensorsystems 12 dargestellt. Dabei weist die Sensorabdeckung 10 zumindest einen Sensorabschnitt 16 und zumindest einen Grundkörper 18 zur Überdeckung des Sensors 14 auf. Dieser ist sensortransparent, um die Wirkungsweise des dahinterliegenden Sensors 14 nicht zu beeinflussen.

In der ersten Ausführungsform gemäß Fig. 1 und 2 ist auf dem Grundkörper 18 zumindest ein um den Sensorabschnitt 16 umlaufender Elektrodenabschnitt 20 vorgesehen. Der vorgesehene piezoaktive Aktuator 22 zur Erzeugung von Schallwellen in der Sensorabdeckung 10 ist an dem zumindest einen umlaufenden Elektrodenabschnitt 20 des Grundkörpers 18 angeordnet.

Für eine einfache Erzeugung der Schallwellen weist der piezoaktive Aktuator 22 eine erste Elektrodenbeschichtung 24, eine zweite Elektrodenbeschichtung 26, und eine piezoaktive Schicht 28 auf. Dabei ist zumindest ein Abschnitt 30 der piezoaktiven Schicht 28 zwischen der ersten Elektrodenbeschichtung 24 und der zweiten Elektrodenbeschichtung 26 angeordnet.

Wie in Fig. 1 gezeigt, entspricht die Grundfläche der ersten Elektrodenbeschichtung 24 und der zweiten Elektrodenbeschichtung 26 der Größe und dem Verlauf des zumindest einen Elektrodenabschnitts 20. Die erste Elektrodenbeschichtung 24 und die zweite Elektrodenbeschichtung 26 des piezoaktiven Aktuators 22 ist in dem ersten Ausführungsbeispiel aus Indium-Zinn-Oxid.

Jedoch deckt die piezoaktive Schicht 28 sowohl den Elektrodenabschnitt 20 als auch den Sensorabschnitt 16 ab. In diesem Fall ist die piezoaktive Schicht 22 aus Polyvinylfluorid und weist zumindest in dem zumindest einen Sensorabschnitt 16 eine Dicke D von 5 nm bis 50 nm. Dadurch wird die Sensortransparenz sichergestellt. Diese Dicke D kann auch 10 nm bis 45 nm, und vorzugsweise 15 nm bis 40 nm, sein, um so die Sensortransparenz zu erhöhen.

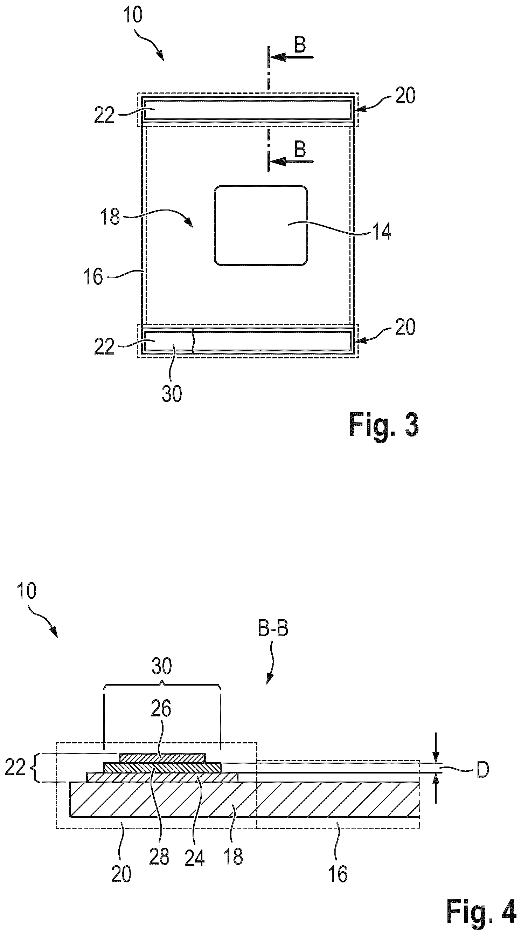

In der zweiten Ausführungsform gemäß Fig. 3 und 4 sind an sich gegenüberliegenden Seiten des Grundkörpers 18 zwei Elektrodenabschnitte 20 auf dem Grundkörper 18 vorgesehen. Die beiden Elektrodenabschnitte 20 weisen also einen abschnittsweisen Verlauf auf dem Grundkörper 18 auf. Diese sind separat modulierbar sind, sodass sie unterschiedliche Frequenzen in die Sensorabdeckung 10 einbringen können, um so beispielsweise der Verschmutzung eine Richtung vorzugeben.

Da hier die piezoaktive Schicht 22 lediglich in den Elektrodenabschnitten 20 und zwischen der ersten Elektrodenschicht 24 und der zweiten Elektrodenschicht 26 vorgesehen ist, ist eine Sensortransparenz der piezoaktiven Schicht 28 nicht notwendigerweise vorzusehen. Demnach kann diese hier eine größere Dicke D aufweisen. Es hat sich bewährt, dass in die piezoaktive Schicht 28 bei dieser Ausführung eine Dicke D von 5 nm bis 500 nm, vorzugsweise eine Dicke D von 10 nm bis 250 nm, weiter vorzugsweise 15 nm bis 150 nm, aufweist.

Auch in der zweiten Ausführungsform ist die piezoaktive Schicht 28 ein Polyvinylfluorid. Allerdings weist die erste Elektrodenbeschichtung 24 jedes piezoaktiven Aktuators 22 und die zweite Elektrodenbeschichtung 26 jedes piezoaktiven Aktuators 22 fluoridiertes Zinnoxid auf. Da allerdings zwei Elektrodenabschnitte 20 vorgesehen sind, können hier pro Elektrodenabschnitt 20 unterschiedliche Materialien für die erste Elektrodenschicht 24 und die zweite Elektrodenschicht 26 verwendet werden. Hierbei kann es sich um eine Kombination aus Indium-Zinn-Oxid und/oder fluoridiertes Zinnoxid und/oder aluminiumdotiertes Zinnoxid und/oder Antimon-Zinn-Oxid handeln.

In einer nicht dargestellten Ausführung, können die Ausführungsformen der Fig. 1 bis 4 als eine Abdeckungsschicht in einem Schichtaufbau aus mehreren Abdeckungsschichten verwendet werden.

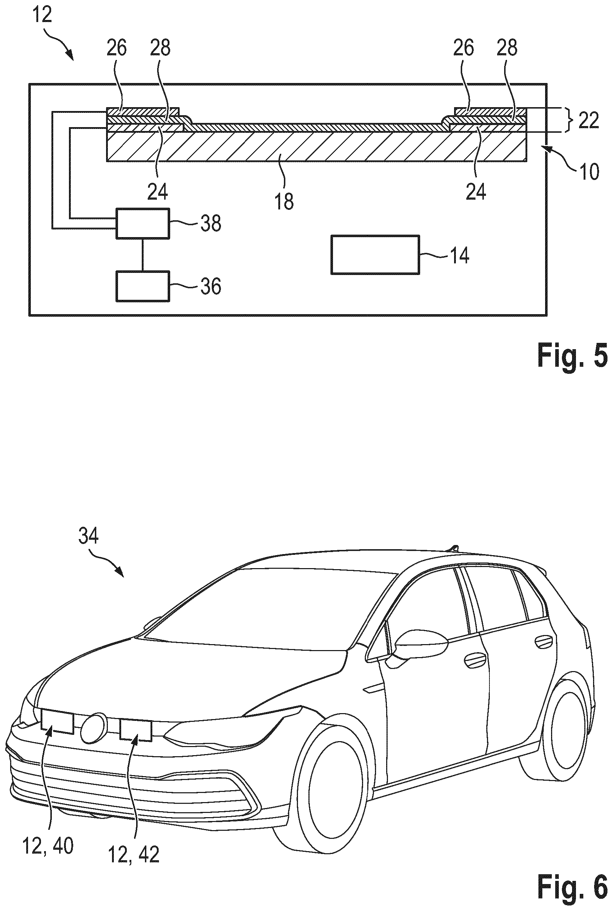

In Fig. 5 ist ein Sensorsystem 12, insbesondere für ein Kraftfahrzeug 34, dargestellt. Das Sensorsystem 12 weist zumindest einen Sensor 14, zumindest eine Sensorabdeckung 10 der ersten Ausführungsform, zumindest eine Spannungsquelle 36, und zumindest einen Schallwandler 38 auf. Dabei ist es auch möglich, dass die Sensorabdeckung 10 der zweiten Ausführungsform gemäß Fig. 3 und 4 entspricht.

Dabei ist die zumindest eine Sensorabdeckung 10 so angeordnet, dass der zumindest eine Sensorabschnitt 16 der Sensorabdeckung 10 den zumindest einen Sensor 14 überdeckt und vor äußeren Umwelteinflüssen schützt. Zusätzlich sind die zumindest eine Spannungsquelle 36 und der zumindest eine Schallwandler 38 mit der zumindest einen ersten Elektrodenbeschichtung 24 und mit der zumindest einen zweiten Elektrodenbeschichtung 26 zum Erzeugen eines Ultraschalls elektronisch verbunden.

Um eine Beeinflussung der verbauten Sensoren 14 zu verhindern, sind die Spannungsquelle 36 und der Schallwandler 38 ausgelegt, einen Frequenzbereich im Ultraschallbereich zu erzeugen, wobei sich der erzeugte Frequenzbereich von den Frequenzbereichen des überdeckten Sensors 14 und/oder beabstandeter Sensoren 14 unterscheidet.

In Fig. 6 ist ein Kraftfahrzeug 34 mit zumindest einem Sensorsystem 12 gemäß Fig. 5 dargestellt. In diesem Fall sind in dem Kraftfahrzeug ein Radarsystem 40 und ein Lidarsystem 42 als Sensorsystem 12 vorgesehen, wobei das Radarsystem 40 eine Sensorabdeckung gemäß Fig 1 und 2 aufweist und das Lidarsystem 42 mit einer Sensorabdeckung gemäß Fig. 3 und 4 ausgestattet ist.

### Bezugszeichenliste

- 10: Sensorabdeckung
- 12: Sensorsystem
- 14: Sensor
- 16: Sensorabschnitt
- 18: Grundkörper
- 20: Elektrodenabschnitt
- 22: piezoaktiver Aktuator
- 24: erste Elektrodenbeschichtung
- 26: zweite Elektrodenbeschichtung
- 28: piezoaktive Schicht
- 30: Abschnitt
- 34: Kraftfahrzeug
- 36: Spannungsquelle
- 38: Schallwandler
- 40: Radarsystem
- 42: Lidarsystem

- D: Dicke

## Patentansprüche

1. Sensorabdeckung (10) für ein Sensorsystem (12) zum Entfernen von wetterbedingten Verschmutzungen zur ungestörten Verwendung eines Sensors (14) des Sensorsystems (12), wobei die Sensorabdeckung (10) zumindest einen Sensorabschnitt (16) aufweist, wobei die Sensorabdeckung (10) zumindest einen Grundkörper (18) zur Überdeckung des Sensors (14) aufweist, wobei auf dem Grundkörper (18) zumindest ein Elektrodenabschnitt (20) vorgesehen ist, und wobei die Sensorabdeckung (10) zumindest einen piezoaktiven Aktuator (22) zur Erzeugung von Schallwellen in der Sensorabdeckung (10) aufweist, wobei der zumindest eine piezoaktive Aktuator (22) an dem zumindest einen Elektrodenabschnitt (20) des Grundkörpers (18) angeordnet ist.

2. Sensorabdeckung (10) nach Anspruch 1,
**dadurch gekennzeichnet,**
**dass** jeder piezoaktive Aktuator (22) eine erste Elektrodenbeschichtung (24), eine zweite Elektrodenbeschichtung (26), und
eine piezoaktive Schicht (28) aufweist, wobei zumindest ein Abschnitt (30) der piezoaktiven Schicht (28) zwischen der ersten Elektrodenbeschichtung (24) und der zweiten Elektrodenbeschichtung (26) angeordnet ist.

3. Sensorabdeckung (10) nach Anspruch 1 oder 2,
**dadurch gekennzeichnet,**
**dass** der zumindest eine Sensorabschnitt (16) sensortransparent ist.

4. Sensorabdeckung (10) nach einem der vorhergehenden Ansprüche,
**dadurch gekennzeichnet,**
**dass** der zumindest eine Elektrodenabschnitt (20) abschnittsweise oder vollflächig auf dem Grundkörper (18) vorgesehen ist.

5. Sensorabdeckung (10) nach einem der vorhergehenden Ansprüche,
**dadurch gekennzeichnet,**
**dass** die piezoaktive Schicht (28) jedes piezoaktiven Aktuators (22) eine Dicke (D) von 5 nm bis 500 nm, vorzugsweise eine Dicke (D) von 10 nm bis 250 nm, weiter vorzugsweise 15 nm bis 150 nm, aufweist.

6. Sensorabdeckung (10) nach einem der vorhergehenden Ansprüche,
**dadurch gekennzeichnet,**
**dass** die piezoaktive Schicht (28) jedes piezoaktiven Aktuators (22) in dem zumindest einen Sensorabschnitt (16) eine Dicke (D) von 5 nm bis 50 nm, vorzugweise 10 nm bis 45 nm, weiter vorzugsweise 15 nm bis 40 nm, aufweist.

7. Sensorabdeckung (10) nach einem der vorhergehenden Ansprüche,
**dadurch gekennzeichnet,**
**dass** die piezoaktive Schicht (28) ein Polyvinylfluorid ist

8. Sensorabdeckung (10) nach einem der vorhergehenden Ansprüche,
**dadurch gekennzeichnet,**
**dass** die erste Elektrodenbeschichtung (24) jedes piezoaktiven Aktuators (22) und/oder die zweite Elektrodenbeschichtung (26) jedes piezoaktiven Aktuators (22) Indium-Zinn-Oxid oder fluoridiertes Zinnoxid oder aluminiumdotiertes Zinnoxid oder Antimon-Zinn-Oxid aufweist.

9. Sensorabdeckung (10) nach einem der vorhergehenden Ansprüche,
**dadurch gekennzeichnet,**
**dass** zumindest zwei piezoaktive Aktuatoren (22) auf jeweils einem Elektrodenabschnitt (20) vorgesehen sind, wobei die zumindest zwei piezoaktiven Aktuatoren (22) separat modulierbar sind.

10. Sensorabdeckung (10) nach einem der vorhergehenden Ansprüche,
**dadurch gekennzeichnet,**
**dass** mehrere Abdeckungsschichten vorgesehen sind, wobei jede Abdeckungsschicht zumindest einen Grundkörper (18) und zumindest einen piezoaktiven Aktuator (22) aufweist.

11. Sensorsystem (12), insbesondere für ein Kraftfahrzeug (34), aufweisend
zumindest ein Sensor (14),
zumindest eine Sensorabdeckung (10) nach einem der vorhergehenden Ansprüche,
zumindest eine Spannungsquelle (36), und
zumindest einen Schallwandler (38),
wobei die zumindest eine Sensorabdeckung (10) so angeordnet ist, dass der zumindest eine Sensorabschnitt (16) der Sensorabdeckung (10) den zumindest einen Sensor (14) überdeckt und vor äußeren Umwelteinflüssen schützt, und
wobei die zumindest eine Spannungsquelle (36) und der zumindest eine
Schallwandler (38) mit der zumindest einen ersten Elektrodenbeschichtung (24) und mit der zumindest einen zweiten Elektrodenbeschichtung (26) zum Erzeugen eines Ultraschalls elektronisch verbunden sind.

12. Sensorsystem (12) nach Anspruch 11,
**dadurch gekennzeichnet,**
**dass** die Spannungsquelle (36) und der Schallwandler (38) ausgelegt sind, einen Frequenzbereich im Ultraschallbereich zu erzeugen, wobei sich der erzeugte Frequenzbereich von den Frequenzbereichen des überdeckten Sensors (14) und/oder beabstandeter Sensoren (14) unterscheidet.

13. Kraftfahrzeug (34) mit zumindest einem Sensorsystem (12) nach Anspruch 11 oder 12.

14. Kraftfahrzeug (34) nach Anspruch 13,
**dadurch gekennzeichnet,**
**dass** das Sensorsystem (12) ein Radarsystem (40) und/oder ein Lidarsystem (42) ist.
